Europäisches Patentamt

European Patent Office

Office européen des brevets

(11) Veröffentlichungsnummer : **0 566 604 B1**

(12) **EUROPÄISCHE PATENTSCHRIFT**

(45) Veröffentlichungstag der Patentschrift :
**15.11.95 Patentblatt 95/46**

(51) Int. Cl.$^6$ : **G11C 29/00**

(21) Anmeldenummer : **92901848.9**

(22) Anmeldetag : **07.01.92**

(86) Internationale Anmeldenummer :
**PCT/DE92/00005**

(87) Internationale Veröffentlichungsnummer :
**WO 92/12520 23.07.92 Gazette 92/19**

(54) **VERFAHREN ZUM TESTEN EINES ALS MAKROZELLE AUF EINEM HALBLEITERBAUSTEIN ANGEORDNETEN SPEICHERS NACH DEM SELBSTTESTPRINZIP.**

(30) Priorität : **11.01.91 DE 4100679**

(43) Veröffentlichungstag der Anmeldung :
**27.10.93 Patentblatt 93/43**

(45) Bekanntmachung des Hinweises auf die
Patenterteilung :
**15.11.95 Patentblatt 95/46**

(84) Benannte Vertragsstaaten :
**AT DE FR GB IT NL**

(56) Entgegenhaltungen :
**EP-A- 0 350 538**
**DE-A- 3 619 255**
**IBM TECHNICAL DISCLOSURE BULLETIN. Bd. 21, Nr. 12, Mai 1979, New York,US;Seite 4942; D. G. EAST: "Address generation for array testing"**

(73) Patentinhaber : **SIEMENS AKTIENGESELLSCHAFT**
**Wittelsbacherplatz 2**
**D-80333 München (DE)**

(72) Erfinder : **RITTER, Hartmut**
**Sudetenweg 22**
**D-8152 Feldkirchen-Westerham (DE)**
Erfinder : **SCHWAIR, Thomas**
**Ostpreussenstrasse 10**
**D-8012 Ottobrunn (DE)**
Erfinder : **MAY, Werner**
**Balanstrasse 69**
**D-8000 München 90 (DE)**
Erfinder : **MAIERHOFER, Johann**
**Gozbertstrasse 7**
**D-8000 München 90 (DE)**

EP 0 566 604 B1

## Beschreibung

Verfahren und Schaltungsanordnungen zum Testen von Speichern sind bekannt. In einem ersten Beispiel basiert das Testverfahren auf einem Testalgorithmus mit deterministischen Testmustern (WO 86/01036 A1). Ein solches Verfahren ist oft nur auf Bit orientierte statische Schreib-Lesespeicher ausgerichtet. Ein Anpassen der Algorithmen auf andere Fehlermodelle ist aufwendig. Bedingt durch das Umschalten zwischen Abwärts- und Aufwärtszählen der Adressen und bedingt durch die unterschiedliche Anzahl von Schreib- und Lesezugriffe pro Testphase ist die Ablaufsteuerung für diese Speichertestalgorithmen sehr komplex. Für wortweise organisierte Schreib/Lesespeicher ist die Testmustererzeugung für die Dateneingänge oft sehr aufwendig.

Aus EP-A 0350 538 ist ein Speichertestverfahren bekannt, das deterministische Testmuster zum Prüfen des Speichers verwendet Wenn der Speicher bitweise geprüft wird, wird in einem ersten Durchgang in die einzelnen Speicherelemente eine "0" eingeschrieben. In einem folgenden Testzyklus werden die Speicherelemente ausgelesen, anschließend eine "1" eingeschrieben und diese wieder gelesen. Ist das Speicherwort wordorientiert, dann werden vorgegebene Testmuster in eine Speicherzelle eingeschrieben und anschließend wieder gelesen.

Speichertestalgorithmen mit deterministischen Mustern, die Nachbarschaftsfehler in dynamischen RAMS abdecken, verursachen meist einen exponentiellen Anstieg der Testzeit und sind meist nur bei spezifischen Speicherfeldarchitekturen einsetzbar.

Neben Speichertestalgorithmen mit deterministischen Testmustern gibt es noch Testalgorithmen mit pseudozufälliger Testdaten- und Adreßerzeugung sowie mit pseudozufälligen Schreib- und Lesezugriffen ( GB 2 172 128 A). Diesem Algorithmus liegt ein universelleres Fehlermodell zugrunde. Mit Hilfe der Stochastik läßt sich für jeden erdenklichen Fehlertyp die Einstell- und Beobachtungswahrscheinlichkeit berechnen. Für ein typisches Fehlermodell eines dynamischen RAMs benötigt man etwa 200 n Schreib/Lesezugriffe, um einen Fehlererkennungsgrad von 99,9% zu erreichen, wobei n die Anzahl der Speicher-Zellen ist. Ein solcher Algorithmus ist besonders für wortorganisierte Schreib/Lese-Speicher geeignet. Der Schaltungsaufwand für eine Selbsttest-Architektur ist kleiner als für Selbsttestverfahren mit deterministischen Testmustern. Die Selbsttest-Architektur läßt sich parametrisieren und ist damit für alle Speicherorganisationen generierbar. Ein Nachteil liegt aber in der relativ hohen Testzeit.

Aus DE-A- 36 19 255 ist ein Testverfahren bekannt, das mit Pseudozufallsfolgen arbeitet. In einem ersten Durchgang wird in alle Speicherzellen des Speichers die Pseudozufallsfolgen eingeschrieben. Nach Beendigung des Einschreibzyklus wird in einem weiteren Auslesezyklus die gespeicherten Daten ausgelesen und mit einem Analysator überprüft, um Fehler festzustellen.

Die der Erfindung zugrundeliegende Aufgabe besteht darin, einen einfachen, effizienten Speichertestalgorithmus anzugeben, der eine kostengünstige Selbsttestarchitektur einer einen Speicher enthaltenden Makrozelle ermöglicht, wobei sich die Makrozelle gut parametrisieren läßt.

Dieses Problem wird mit Hilfe der in Anspruch 1 angegebenen Verfahrensschritte gelöst.

Durch Verwendung des vorgeschlagenen Speichertestalgorithmus, der für ein Selbsttestverfahren geeignet ist, wird eine geringe Testzeit erreicht. Der Speichertestalgorithmus ist universell einsetzbar, für verschiedenartigste Fehlermodelle verwendbar und ermöglicht eine einfache Parametrisierbarkeit der Architektur. Schließlich ist das Verfahren automatisierbar und kann in ein hierarchisches Selbsttestkonzept eingebunden werden.

Soll ein dynamischer Speicher getestet werden, dann ist es vorteilhaft, wenn zwischen der ersten Phase und der zweiten Phase eine Refreshphase eingefügt wird.

Die Anzahl der Testzyklen in der weiteren Phase hängt vom Fehlerkennungsgrad ab, der z.B. anhand der Kopplungsfehler zwischen zwei Speicherelementen berechenbar ist.

Eine einfache Erzeugung der pseudorandom Testmuster in der weiteren Phase kann über ein LFSR-Schieberegister (Linear Feedback Shift Register) erfolgen. Aus der Anzahl der Testzyklen kann die Breite des LFSR-Registers berechnet werden.

Weiterbildungen ergeben sich aus den Unteransprüchen.

Anhand der Figuren wird die Erfindung weiter erläutert. Es zeigen

Figur 1 den verwendeten Speichertestalgorithmus,

Figur 2 eine Schaltungsanordnung zur Durchführung des Testalgorithmus,

Figur 3 einen Aufbau des Controllers,

Figur 4 die Betriebszustände der Makrozelle mit Speicher,

Figur 5 ein Zeitdiagramm für den Selbsttest.

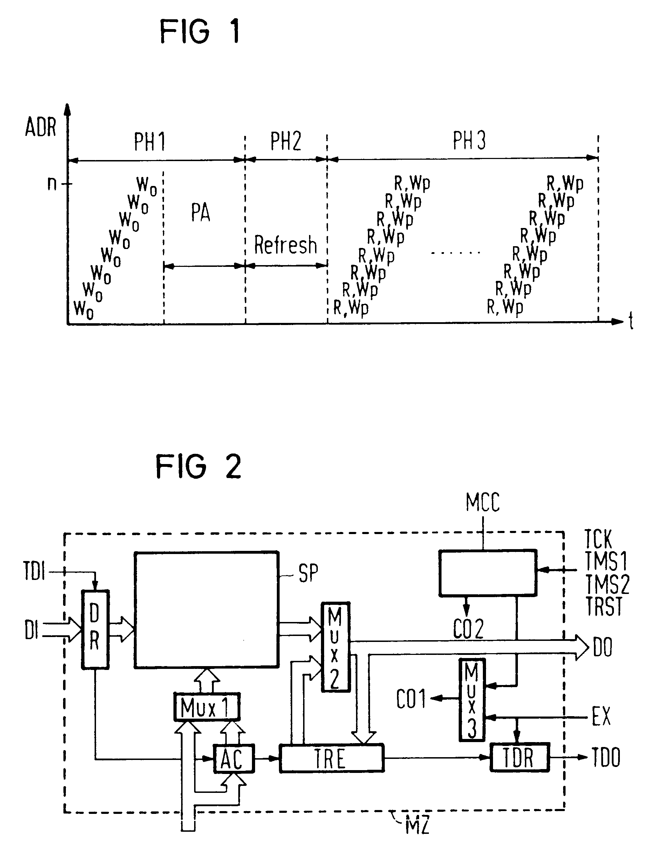

Eine Makrozelle MZ, die einen Speicher SP enthält, ergibt sich aus Figur 2. Die Makrozelle ist zusammen mit anderen Schaltungsblöcken auf einem Halbleiterbaustein angeordnet.

Der Speicher SP soll nun nach der Selbsttestmethode unter Verwendung der sowieso vorhandenen Register und unter Hinzufügung weiterer Selbsttestschaltkreise prüfbar sein. Um die weiteren Selbsttestschaltkreise möglichst einfach zu machen und trotzdem die im Speicher SP auftretenden Fehler möglichst umfassend feststellen zu können, wird ein Speichertestalgorithmus gemäß der Figur 1 verwendet. Hier sind über der Zeit t Adressen ADR angegeben und dargestellt, welche Testmuster in die Speicherzellen des Speichers eingeschrieben werden und wie diese gelesen und wieder eingeschrieben werden.

Der Speicher SP enthält dabei nicht nur das Speicherfeld bestehend aus Speicherzellen, die wiederum Speicherelemente aufweisen; er enthält auch zum Betrieb des Speichers erforderliche Decoder und Schreib/Leseschaltkreise.

In einer ersten Phase PH1 werden in alle Speicherelemente der Speicherzellen des Speichers deterministische Testmuster eingeschrieben. Je nach zu prüfender Speichertechnologie ist es sinnvoll, alle Bits der Speicherelemente der n Speicherzellen mit "0" ($W_0$) oder mit "1" ($W_1$) zu laden. Im Ausführungsbeispiel der Figur 1 sind dies "0"en. Damit werden alle Speicherzellen mit Elektronen geladen und das Halten der Ladungsmenge überprüft. Dazu wird eine Pause PA innerhalb der Phase PH1 eingelegt.

Sollte der zu prüfende Speicher ein dynamischer Speicher sein, würde auf die Phase PH1 eine weitere Phase PH2 folgen, in der die Speicherzellen aufgefrischt werden. Damit dieses Auffrischen den Testablauf nicht beeinflußt, ist die Refreshlogik nur in der weiteren Phase PH2 aktiv. Somit läßt sich überprüfen, ob die in der Phase PH1 eingeschriebenen Daten korrekt aufgefrischt werden. Anschließend wird die Refreshlogik wieder deaktiviert. Bei statischen Speichern kann auf die Phase PH2 verzichtet werden.

In einer letzten Phase PH3 werden alle Speicherzellen des Speichers SP in umlaufender Adreßfolge gelesen (abgekürzt mit R dargestellt) und dann mit Pseudorandom-Testmustern (abgekürzt mit $W_P$ bezeichnet) beschrieben. Die alternierenden Schreib-Lesezugriffe auf alle Adressen werden solange wiederholt in m Zyklen, bis der gewünschte Fehlererkennungsgrad F erreicht ist.

Zum Testen des Speichers werden somit in einer ersten Phase PH1 deterministische Testmuster verwendet und in einer letzten Phase PH3 Pseudorandom-Testmuster eingesetzt. Dabei wird jede Speicherzelle zunächst gelesen und anschließend sofort mit einem Pseudorandom-Testmuster beschrieben, die jeweils in einem Testzyklus unterschiedlich sind.

Die Anzahl der benötigten Testzyklen m ist abhängig vom individuellen Fehlermodell und dem geforderten Fehlererkennungsgrad. Die Fehlererkennung läßt sich in zwei Teilaufgaben zerlegen. Einerseits müssen die zu betrachtenden Fehler eingestellt werden, um sie andererseits beobachten zu können. Der Ablauf des Speichertestalgorithmus garantiert die Beobachtung aller eingestellten Fehler. Damit müssen für die Fehlererkennung nur noch die Wahrscheinlichkeiten für das Einstellen der Fehler berechnet werden. Im folgenden werden die Wahrscheinlichkeiten in Abhängigkeit von der Testlänge berechnet, mit der die Fehler mit Hilfe von Pseudorandom-Testmustern eingestellt werden. Aufgrund der Pseudorandom-Eigenschaften der Testmuster an den Eingängen des Speichers gilt:

PW1 (p, i) = PW0 (p,i) = 0,5:      PW1 ist die Wahrscheinlichkeit, in ein Speicherelement (p,i) einer Zelle eine "1" bzw. eine "0" zu schreiben.

PL0(p,i) = PL1(p,i) = 0,5:      Wahrscheinlichkeit, daß das Speicherelement (p,i) eine "0" oder eine "1" enthält.

$P_{lk}(i) = 2/2^k = 1/2^{k-1}$:      Wahrscheinlichkeit, daß k Bits des Wortes i identisch (alle "0" oder alle "1") sind.

Dabei sind:

(p,i):      das p-te Bit des i-ten Wortes
w      Bitbreite des Wortes
n      Anzahl der Zellen im Speicher
W1      Es wird eine "1" in ein Speicherelement geschrieben
W0      Es wird eine "0" in ein Speicherelement geschrieben.

Zunächst werden Stuck-at-Fehler behandelt; bei ihnen liegen eine oder mehrere Speicherelemente ständig auf "0" bzw. "1". Das entspricht einem Kurzschluß mit Masse oder mit Versorgungsspannung.

Um einen Stuck-at-"0"-Fehler erkennen zu können, muß eine "1" in das Speicherelement geschrieben und das Speicherelement ausgelesen werden. Durch den Testablauf ist sichergestellt, daß jedes Speicherelement innerhalb eines Testzyklus erfaßt wird. Die Wahrscheinlichkeit in m Schreibzugriffen keine "1" in das Element zu schreiben und damit den Fehler nicht zu erkennen, beträgt:

$$P_S = (1 - PW1 (p,i))^m = (P_{max})^m = (0,5)^m \quad (1)$$

Für Stuck-at-1-Fehler gilt Formel (1) analog.

Transitionsfehler liegen dann vor, wenn ein oder mehrere Speicherelemente sich nicht mehr mit dem komplementären Inhalt laden lassen, nachdem sie mit einem bestimmten Wert geladen sind. Dabei existieren zwei Typen von Transitionsfehlern. Zum Beispiel hat das Speicherelement (p,i) den Zustand "0". Der Übergang von "0" nach "1" bleibt wirkungslos.

Um diesen Fehler einzustellen, muß in dem Speicherelement (p,i) eine "0" stehen und in der anschließenden Aktion auf dieses Speicherelement eine "1" geschrieben werden. Die Wahrscheinlichkeit, diesen Fehler in m Schreibzugriffen auf das Speicherelement (p,i) nicht einzustellen, beträgt:

$$P_T = (1 - PL0 ((p,i) * PW1(p,i))^m = (P_{max})^m = (0,75)^m \quad (2)$$

Das gleiche Ergebnis erhält man für den anderen Typ von Transitionsfehlern.

Unter dem Begriff Kopplungsfehler werden Kurzschlüsse und kapazitive Kopplungen zwischen zwei beliebigen Speicherelementen i und j zusammengefaßt. Ein Schreibzugriff auf ein Speicherelement i verändert den Inhalt des Speicherelementes j. Eine Kopplung wird dabei als beidseitig bezeichnet, wenn sich die beiden Speicherelemente gegenseitig beeinflussen. Das Beschreiben des Speicherelementes i verändert den Inhalt des Speicherelementes j und umgekehrt. Es bestehen somit vier Typen von Kopplungsfehlern zwischen zwei Speicherelementen. Zum Beispiel verursacht das Schreiben einer "1" in das Speichererlement (p,i) einen Übergang von "0" nach "1" in dem Speicherelement (q, j), falls q, j eine "0" enthält. Im anderen Fall ergibt sich keine Wirkung. Um diesen Fehler einzustellen, muß in das Speicherelement (p,i) eine "1" geschrieben werden, und die Zelle q, j muß eine "0" enthalten. Beim Lesen des Wortes j wird der Fehler erkannt. Die Wahrscheinlichkeit, diesen Fehler in m Speicherzugriffen auf das Speicherelement (p, i) nicht einzustellen, beträgt:

$$P_K = (1 - PL0 (q,j) * PW1 (p,i))^m = (P_{max})^m = (0,75)^m \quad (3)$$

Für die drei anderen Kombinationen ergibt sich das gleiche Ergebnis.

Auf entsprechende Weise können auch Wahrscheinlichkeiten für Nachbarschaftsfehler berechnet werden. Hier beeinflussen mehrere Speicherelemente gemeinsam ein Basisspeicherelement. Dabei lassen sich zwei Typen klassifizieren. Der Inhalt des Basisspeicherelementes kann abhängig von den Inhalten der Nachbarschaftsspeicherelementen nicht mehr geändert werden. Dies wird als passiver Nachbarschaftsfehler bezeichnet. Bewirkt eine Änderung des Inhalts eines Nachbarschaftsspeicherelementes gleichzeitig eine Änderung des Inhalts des Basisspeicherelementes, so wird von einem aktiven Nachbarschaftsfehler gesprochen.

In den folgenden Berechnungen bezüglich der Anzahl m der Zyklen für den Algorithmus werden Nachbarschaftsfehler ausgenommen. Die geringste Einstellwahrscheinlichkeit ergibt sich somit für Kopplungsfehler. Hier errechnet sich die Wahrscheinlichkeit, daß ein solcher Fehler nicht eingestellt wird, zu $P_{min} = P_K = 0,75^m$. Die Zahl m der zu durchlaufenden Zyklen für einen geforderten Fehlerkennungsgrad F läßt sich somit leicht errechnen:

$$F = 1 - P_{min} = 1 - (0,75)^m \quad (4)$$
$$m = \ln(1 - F)/(\ln 0,75).$$

Für einen Fehlerkennungsgrad F von 99,9%, d.h. für F = 0.999 ergibt sich eine Anzahl von m = 25 Schreib/Lese-Zyklen für jede der n Adressen. Werden die Nachbarschaftsfehler mitberücksichtigt, dann ergibt sich für diesen Fall ein Fehlererkennungsgrad von F = 80%. Um für diesen Fall einen Fehlererkennungsgrad von F = 99,9% zu erreichen, muß die Anzahl der Zyklen m auf 71 erhöht werden.

Die Wahrscheinlichkeitsberechnungen setzen voraus, daß sich der Zustand des Speichers während der m Zyklen nicht wiederholt. Daher gelten Anforderungen an die Periodendauer und damit auch an die Mindestbreite w des Testdatengenerators, der z.B. als LFSR realisiert sein kann, am Eingang des Speichers. Ein LFSR z.B. mit primitivem charakteristischen Polynom der Breite w erzeugt Testmuster, die sich nach $2^w-1$ Zyklen wiederholen. Nach $(2^w-1)xn$ Zyklen befindet sich der Speicher wieder in seinem Anfangszustand. (Dies ist nur zutreffend, wenn die Zykluslänge des LSFR kein Vielfaches von n ist). Damit sich die Zustände im Speicher nicht wiederholen, muß dieser Wert größer als die Zahl der Schreibzugriffe sein:

$$(2^w-1)n \geq (m+1)n$$
$$ld(2^w) \geq ld(m+2) \quad (5)$$
$$w \geq ld(m+2)$$

Für einen gewünschten Fehlerkennungsgrad von 99,9% sind 25 x n Schreib-Lesezugriffe notwendig. Mit m = 25 erfüllt w = 5 die obige Relation. Die Breite des LFSR sollte in diesem Fall mindestens 5 Bit betragen. Ist die Datenbreite des Speichers geringer, so wird nur eine Teilmenge der Registerstellen abgegriffen.

Ein Aufbau einer Schaltungsanordnung zur Prüfung eines Speichers SP nach dem oben beschriebenen Selbsttestalgorithmus ergibt sich aus Figur 2. Dem Speicher SP ist ein Datenregister DR vorgeschaltet, in dem von außen kommende Daten DI eingespeichert werden können und von dort dem Speicher SP zugeführt werden können. Das Datenregister DR wird somit zur Pufferung der eingehenden Datenworte im Betrieb verwendet. Zur Testmustergenerierung für den Speicher SP während des Selbsttests kann es ebenfalls verwendet werden, wenn es als LFSR schaltbar ist. Weiterhin kann das Datenregister in einem externen Testmodus Daten übernehmen und z.B. einem Register TDR weitergeben. Schließlich können über einen Eingang TDI Daten in das Datenregister eingeschoben werden und in einem internen Testmodus an den Speicher angelegt werden.

Das Datenregister DR kann zu einem linear rückgekoppelten Schieberegister erweitert werden, das $2^w$-1 Random-Testmuster erzeuen kann, wobei dann w die Datenwortbreite ist.

Mit Hilfe eines Adreßzählers AC können Adressen für den Speicher SP erzeugt werden und über einen Multiplexer MUX1 dem Speicher zugeführt werden. Es ist auch möglich, über den Multiplexer MUX1 die Adressen von außen zuzuführen.

Mit Hilfe eines Testantwortbewerters TRE können die Testantworten vom Speicher SP bewertet werden. Die vom Speicher SP gelesenen Daten werden über einen Multiplexer MUX2 an den Datenausgang DO gelegt. Am Datenausgang DO ist zusätzlich der Testantwortbewerter TRE angeschlossen, der als Register realisiert sein kann. TRE erfüllt zwei Aufgaben: Während des Selbsttests wird über alle ausgelesenen Worte, die Testantworte, eine Signatur gebildet, die am Ende des Prüfvorgangs über einen Ausgangs TDO seriell ausgeschoben werden kann.

Zusätzlich läßt sich über den seriellen Eingang TDI zum Datenregister DR ein Datenwort einschieben, mit dem die nachfolgenden Schaltungskreise hinter dem Datenausgang DO über den Multiplexer MUX2 stimuliert werden können.

Weiterhin kann ein Testdatenregister TDR vorgesehen sein. Die Ablaufsteuerung im Normalbetrieb wird außerhalb der Makrozelle durchgeführt. Diese erzeugt Steuersignale wie Schreib/Lesesignale (W/R), ein Signal zum Aktivieren bzw. Deaktivierung des Speichers und Taktsignale für die Register. Diese externen Steuersignale EX werden über einen Multiplexer MUX3 als interne Steuersignale CO1 zugeführt. Für den Selbsttest werden alle Steuersignale und Taktsignale dagegen von einem internen Makrozellencontroller MCC erzeugt. Zur Erhöhung der Beobachtbarkeit können die externen Steuersignale EX in das Schieberegister TDR eingeschoben und seriell über den Ausgang TDO ausgeschoben werden.

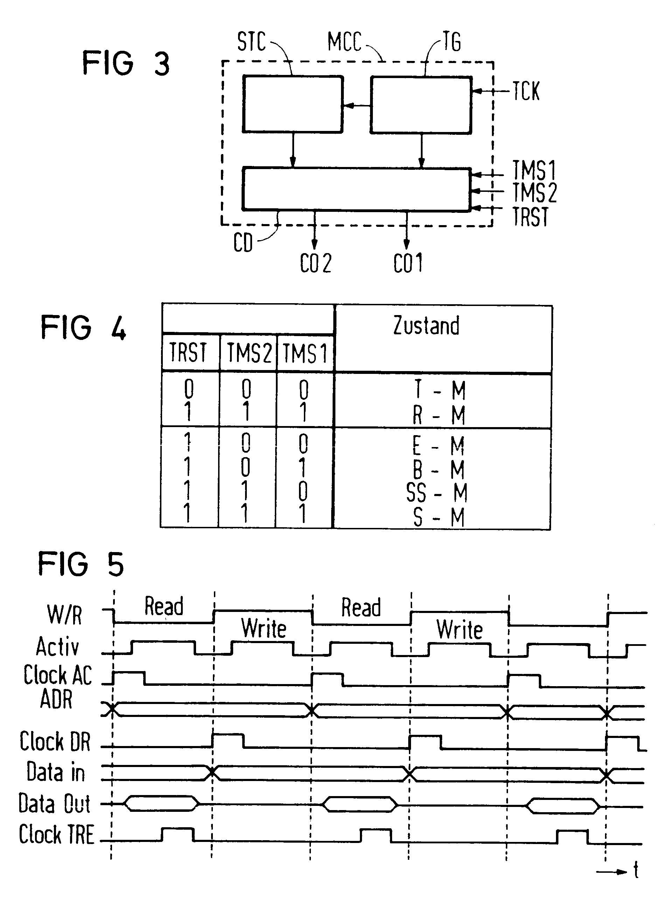

Der Makrozellencontroller MCC ist nur während des Ablaufs des Selbsttestes wirksam und erhält von einem übergeordneten Controller des Halbleiterbausteins Steuersignale TMS1, TMS2 und TRST sowie ein Taktsignal TCK. Er besteht gemäß der Figur 3 aus einem Selbsttest-Controller STC, einem Taktgenerator TG und einem Decoder CD.

Der Ablauf des Selbsttests wird von dem Selbsttest-Controller STC überwacht. Wenn die Anzahl der Schreib/Lesezugriffe und damit die Zahl der Zustände des Controllers festliegt, läßt sich der Selbsttest-Controller STC aus einem rückgekoppelten Schieberegister aufbauen.

Ein zusätzlch vorgesehener Taktgenerator TG liefert alle für den Selbsttest notwendigen Taktsignale, die von dem externen Testtakt TCK abgeleitet werden.

Der Decoder CD decodiert für die sechs Betriebsmodi nach Figur 4 die drei Steuersignale TMS1, TMS2 und TRST und überwacht die Umkonfigurierung der einzelnen Funktionsblöcke des Speichers SP.

Aus der Figur 4 kann entnommen werden, welche Konfiguration die einzelnen Funktionsblöcke oder Teile der Makrozelle einnehmen, wenn bestimmte Kombinationen von Steuersignalen TMS1 TMS2 und TRST vorliegen. Im Betriebsmodus B-M arbeitet das Datenregister DR als parallel lad- und lesbares Register. Die Register TRE und TDR sind dagegen deaktiviert.

In einem Shift/Scan-Modus SS-M wird über den Eingang TDI ein neues Testmuster eingeschoben. Gleichzeitig wird die aktuelle Adresse im Adressenzähler AC, das ausgelesene Datenwort im Register TRE und die Steuerbits im Register TDR über den Ausgang TDO ausgeschoben.

Im internen Testmodus T-M wird ein einziger Schreib/Lesezugriff vom Makrozellen-Controller MCC durchgeführt. Deshalb ist das Datenregister DR, der Adreßzähler AC und das Register TRE aktiv, das Testdatenregister TDR dagegen inaktiv.

Im externen Test-Modus E-M lassen sich Daten (= Testantowrten der vorgegschalteten Schaltungskreise) in das Datenregister DR und die Adreßbits in den Adreßzähler AC parallel laden und gleichzeitig die Schaltungskreise hinter dem Datenausgang DO mit dem Inhalt des Registers TRE stimulieren. Deshalb sind das Datenregister DR, der Adreßzähler AD, das Register TRE und TDR aktiv.

Im Reset-Modus R-M werden alle Register in einen definierten Anfangszustand für den Selbsttest gebracht.

Während des Selbsttest-Modus S-M werden die einzelnen Register umkonfiguriert und arbeiten wie oben beschrieben. Das heißt das Datenregister DR ist als LFSR-Register geschaltet, der Adreßzähler arbeitet als Zähler, das Register TRE als Testantwortbewerter und das Testdatenregister TDR ist inaktiv. Alle Steuersignale und Takte werden vom Makrozellen-Controller MCC geliefert. Es werden die drei Phasen gemäß Figur 1 abgearbeitet. Am Ende wird die Signatur im Testantwortbewerter TRE gebildet und dann im Shift-Scan-Modus ausgeschoben. Die Steuersignale, die die Betriebsmodi festlegen, werden als Steuersignale CO2 den Registern zugeführt; die Steuersignale, die die externen Steuersignale EX ersetzen, über den Multiplexer MUX3 als Steuersignale CO1 zugeführt.

Ein Zeitdiagramm des Selbsttestmodus zeigt Figur 5. Über der Zeit t ist das Schreiblesesignal W/R, das

EP 0 566 604 B1

Taktsignal für den Zähler AC, die Adresse ADR, das Taktsignal für das Datenregister DR, die einzulesenden Daten, die auszulesenden Daten und das Taktsignal für das Register TRE dargestellt.

Zur Bewertung der Signatur ist selbstverständlich erforderlich, daß eine Sollsignatur für den Gutfall vorliegt. Die Steuerung aller Betriebsmodi des Speichers läßt sich über die Schnittstelle TMS1, TMS2, TRST, TCK abwickeln. Diese 4 Bitbreite standardisierte Schnittstelle mit dem zugehörigen Makrozellencontroller MCC läßt sich auch für den Selbsttest anderer Makrozellen, wie Multiplizierer oder AIU usw. einsetzen. Es entsteht somit eine einheitliche und hierarische Testumgebung. Die Makrozellen können zunächst getrennt von einander parallel einem Selbsttest unterzogen werden. Anschließend werden die Schaltungen zwischen den Makrozellen im externen Testmodus überprüft. Das ganze kann von einem übergeordneten Bausteincontroller gesteuert werden.

Für den Speichertest-Algorithmus läßt sich eine einfache nach Datenbreite, Adreßbreite und Testlänge parametrisierbare Selbsttestarchitektur realisieren. Der Speicher inklusive Selbsttestschaltung ist damit automatisch erzeugbar.

Der Selbsttestkontroller MCC ist nur durch die gewünschte Testgüte (die Laufzahl der Zyklen) festgelegt. Der Taktgenerator TG und der Decoder CD sind durch die Makrozelle, also den Speicher festgelegt. Die Breite des Testdatenregisters TDR ist durch die Anzahl der externen Steuersignale bestimmt. Alle weiteren Register sind nur von der Daten- und Adreßbreite abhängig.

**Patentansprüche**

1. Verfahren zum Selbsttest eines als Makrozelle auf einem Halbleiterbaustein angeordneten Speichers (SP), der jeweils Speicherelemente aufweisende Speicherzellen enthält,
   a) bei dem in einer ersten Phase (PH1) in alle Speicherelemente der Speicherzellen des Speichers (SP) bitweise logische Werte einer Art ("0" oder "1") eingespeichert werden und anschließend eine Pause folgt,
   b) bei dem in einer weiteren Phase (PH3) jeweils in einem Testzyklus in umlaufender Adreßfolge jede Speicherzelle adressiert wird,
      aa) in einem ersten Testzyklus die jeweils adressierte Speicherzelle zunächst gelesen und anschließend vor Adressierung der folgenden Speicherzelle mit einem Pseudorandomtestmuster beschrieben wird und nacheinander dies für alle Speicherzellen durchgeführt wird,
      bb) in jeweils weiteren Testzyklen entsprechend aa) mit anderen jeweils bei jedem Testzyklus unterschiedlichen Pseudorandomtestmuster vorgegangen wird,
   c) und bei dem anhand der vom Speicher abgegebenen Testantwortmuster fehlerhafte Speicherzellen festgestellt werden.

2. Verfahren nach Anspruch 1, bei dem zur Prüfung eines dynamischen Speichers zwischen der ersten Phase (PH1) und der weiteren Phase (PH3) eine Phase (PH2) eingefügt wird, in der der Speicher einem Refresh unterzogen wird.

3. Verfahren nach Anspruch 1 oder 2, bei dem die Anzahl m der Testzyklen in der weiteren Phase (PH3) abhängig vom gewünschten Fehlererkennungsgrad (F) nach folgender Formel berechnet wird:
$$m = \ln(1 - F)/(\ln P_{max})$$
$$(0 \leqq P_{max} <_1)$$
   wobei
      $P_{max} = 1 - PL \times PW$ oder
      $P_{max} = 1 - PW$
   ist und
   PL     die Wahrscheinlichkeit ist, daß ein Speicherelement einer Zelle eine "0" bzw. "1" enthält
   PW     die Wahrscheinlichkeit ist, daß in ein Speicherelement einer Zelle eine "1" bzw. eine "0" eingeschrieben wird.

4. Verfahren nach Anspruch 3, bei dem zur Erzeugung der Pseudorandom-Testmuster ein LFSR verwendet wird von solcher Breite, daß während der m Testzyklen die Testmuster unterschiedlich sind.

5. Verfahren nach Anspruch 4, bei dem die Breite w des LFSR nach der Formel
   ld: Logarithmus dualis
   $w \geqq ld(m+2)$ bit

6

berechnet wird.

## Claims

1. Process for the self-testing of a memory (SP) arranged as a macrocell on a semiconductor component and containing memory cells each having memory elements,

   a) in which in a first phase (PH1) logical values of one type ("0" or "1") are stored bit by bit in all the memory elements of the memory cells of the memory (SP) and there subsequently follows a pause,

   b) in which in a further phase (PH3), in a test cycle in each case, each memory cell is addressed in recurring address sequence,

   aa) in a first test cycle the respectively addressed memory cell is first read then, before the following memory cell is addressed, is described with a pseudorandom test pattern and this is carried out successively for all the memory cells,

   bb) in respectively further test cycles the procedure is carried out in accordance with aa) using other pseudorandom test patterns which are in each case different in each test cycle,

   c) and in which defective memory cells are established on the basis of the test response patterns delivered by the memory.

2. Process according to Claim 1, in which, for testing a dynamic memory, a phase (PH2) in which the memory is subjected to a refresh is included between the first phase (PH1) and the further phase (PH3).

3. Process according to Claim 1 or 2, in which the number m of test cycles in the further phase (PH3) is calculated as a function of the desired degree of error detection (F) by the following formula:

$$m = \ln(1 - F)/(\ln P_{max}),$$
$$(0 \leqq P_{max} < 1)$$

   where
   $P_{max} = 1 - PL \times PW$ or
   $P_{max} = 1 - PW$
   and
   PL    is the probability of a memory element of a cell containing a "0" or "1"
   PW    is the probability of a "1" or "0" being written to a memory element of a cell.

4. Process according to Claim 3, in which an LFSR of such a width that the test patterns are different during the m test cycles is used for generating the pseudorandom test patterns.

5. Process according to Claim 4, in which the width w of the LFSR is calculated by the formula
   ld: Logarithmus dualis
   $w \geqq ld(m+2)$ bit.

## Revendications

1. Procédé d'autotest d'une mémoire (SP) se présentant sous la forme d'une macrocellule sur un composant à semi-conducteur, qui comporte des cellules de mémoire comportant chacune des éléments de mémoire,

   a) dans lequel on mémorise dans une première phase (PH1) des valeurs logiques binaires d'un type ("0" ou "1") dans tous les éléments de mémoire des cellules de la mémoire (SP) puis vient une pause,

   b) dans lequel on adresse chaque cellule de mémoire dans une autre phase (PH3), dans un cycle de tests dans une séquence d'adresses se répétant,

   aa) dans un premier cycle de tests, on lit d'abord la cellule de mémoire adressée puis on écrit dans celle-ci, avant l'adressage de la cellule de mémoire suivante, un échantillon de test pseudo-aléatoire et on effectue cette opération successivement pour toutes les cellules de mémoire,

   bb) dans les cycles de tests suivants, on procède sur d'autres échantillons de test pseudo-aléatoire, différents à chaque cycle de tests, selon aa)

   c) et dans lequel on détermine des cellules de mémoire erronées en référence à l'échantillon de réponse de test fourni par la mémoire.

2. Procédé suivant la revendication 1, caractérisé en ce que l'on insère, entre la première phase (PH1) et la phase suivante (PH3), une phase (PH2), qui est destinée au contrôle d'une mémoire dynamique, au cours de laquelle on soumet la mémoire à un rafraîchissement.

3. Procédé suivant la revendication 1 ou 2, caractérisé par le fait que l'on calcule le nombre m de cycles de tests dans la phase suivante (PH3), en fonction du degré de détection d'erreur (F) souhaité, selon la formule suivante:

$$m = \ln(1 - F)/(\ln P_{max})$$
$$(0 \leqq P_{max} < 1)$$

où

$P_{max} = 1 - PL \times PW$ ou

$P_{max} = 1 - PW$

et

PL est la probabilité qu'un élément de mémoire d'une cellule contienne un "0" ou un "1".

PW est la probabilité qu'un "0 ou un "1" soit enregistré dans un élément de mémoire d'une cellule.

4. Procédé suivant la revendication 3, caractérisé par le fait que l'on utilise un registre à décalage à boucle fermée linéaire LFSR pour la production de l'échantillon de test pseudo-aléatoire, d'une largeur telle que pendant les m cycles de tests, les échantillons de test soient différents.

5. Procédé suivant la revendication 4, caractérisé par le fait que l'on calcule la largeur w du registre à décalage à boucle fermée linéaire LFSR selon la formule :

ld: logarithme de base 2

$w \geqq ld(m+2)$ bit.

# FIG 1

# FIG 2

**FIG 3**

**FIG 4**

| | | | Zustand |
|---|---|---|---|
| TRST | TMS2 | TMS1 | |
| 0 | 0 | 0 | T – M |
| 1 | 1 | 1 | R – M |
| 1 | 0 | 0 | E – M |
| 1 | 0 | 1 | B – M |
| 1 | 1 | 0 | SS – M |
| 1 | 1 | 1 | S – M |

**FIG 5**